# EUROPEAN PATENT SPECIFICATION

(11) **EP 0 488 647 B1**
(45) Date of publication and mention of the grant of the patent: **30.09.1998**
(21) Application number: 91310878.3
(22) Date of filing: 26.11.1991
(51) Int. Cl.: H01L 27/148

(54) **A solid-state imaging device**
Festkörper-Bildaufnahmevorrichtung
Dispositif d'imagerie à l'état solide

(30) Priority: 29.11.1990 JP 336257/90
(43) Date of publication of application: 03.06.1992
(60) Divisional application: 98200590.2
(73) Proprietor: NATIONAL SPACE DEVELOPMENT AGENCY OF JAPAN, Minato-ku Tokyo (JP); MITSUBISHI DENKI KABUSHIKI KAISHA, Tokyo 100 (JP)
(72) Inventor: Masuda, Takeshi, c/o National Space Dev. Agency, Tokyo (JP); Yashiro, Kiyotaka, c/o National Space Dev. Agency, Tokyo (JP); Miyachi, Yuji, c/o National Space Dev. Agency, Tokyo (JP); Shiraishi, Tadashi, c/o Mitsubishi Denki K.K., Itami-shi, Hyogo-ken (JP)
(74) Representative: Beresford, Keith Denis Lewis

(56) References cited:
- US-A- 4 647 977
- PATENT ABSTRACTS OF JAPAN, unexamined applications, E field, vol. 7, no. 239, October 25, 1983 THE PATENT OFFICE JAPANESE GOVERNMENT page 157 E 206

## Description

### FIELD OF THE INVENTION

The present invention relates to a solid-state imaging device and, more particularly, to a structure of a charge input means of a charge coupled device (hereinafter referred to as CCD).

### BACKGROUND OF THE INVENTION

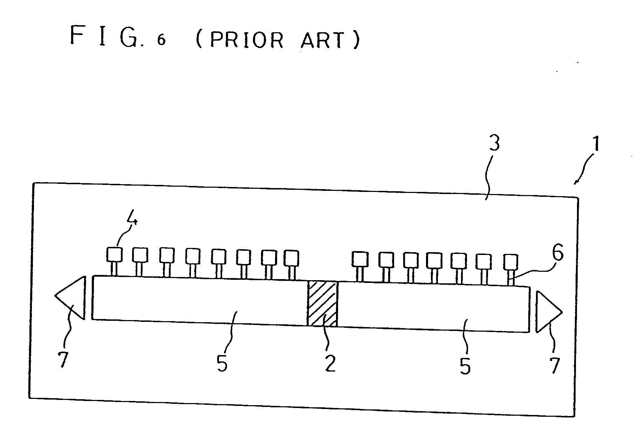

In linear image sensors, signal charges generated in a plurality of light receiving elements arranged on a one-dimensional array are read out by one CCD. Recently, needs for higher resolution have been increased and the number of light receiving element has been increased. However, as the number of light receiving element increases, the stage of CCD increases, resulting in a deterioration in overall transfer efficiency, a high-speed data rate or the like. In order to solve these problems, a solid-state imaging device shown in figure 6, in which light receiving elements are divided in the middle and signal charges are read out by two CCDs arranged in serial, has been proposed.

In figure 6, which depicts a not published prior art device, a plurality of photodiodes (light receiving elements) 4 constituting a light-to-electricity conversion part are arranged in a line on a semiconductor substrate 3, and two CCDs 5 are arranged in parallel with the photodiode array. Respective photodiodes 4 are connected to the charge transfer part of the CCD 5 via transfer gates 6 and signal charges stored in the photodiodes 4 are transferred to the CCD 5 by the ON operation of the transfer gates 6. In addition, output amplifiers 7 are provided at the ends of the CCDs 5 and signal charges transferred through the CCDs 5 are amplified in the output amplifiers 7 and output from the solid-state imaging element 1. A charge input means 2 is provided between the initial stages of the CCDs 5, whereby charges, other than the charges from the photodiodes, are injected into the CCDs 5 from outside. This charge input means 2 electrically supplies charges to the CCDs 5 at a time other than during the imaging mode thereby to check and calibrate the CCDs 5 and the output amplifiers 7 or to test the respective transfer electrodes constituting the CCD 5 in the production process of the CCD 5.

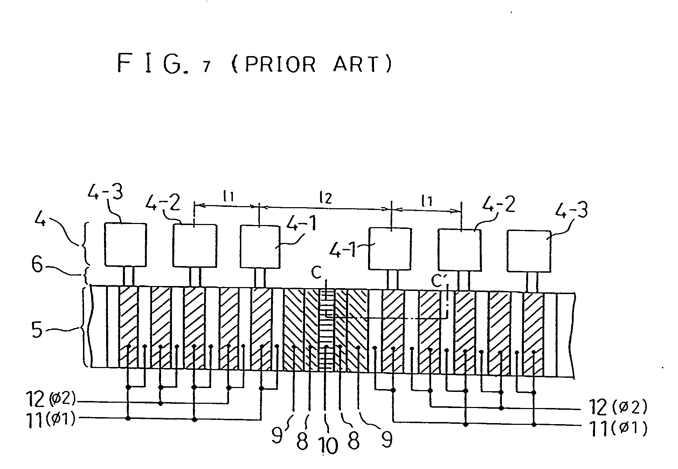

Figure 7 is a plan view showing the structure of the charge input means 2 in detail. In figure 7, reference numeral 10 designates a charge input terminal. Charge input controlling gates 8 and 9, which control the quantity of charges input from the charge input terminal 10, are provided at both sides of the charge input terminal 10. Reference numerals 11 and 12 designate transfer electrodes of the CCD 5.

Operation at the time of charge input mode will be described hereinafter.

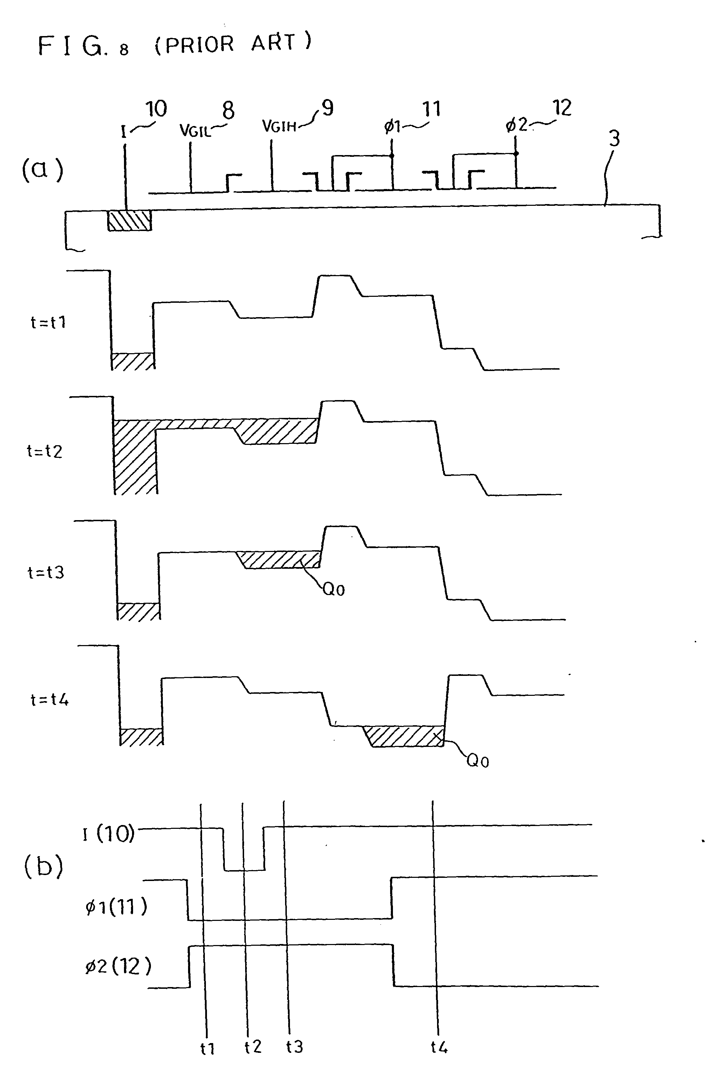

Figure 8 (a) is a diagram schematically showing a cross-section taken along a line C - C' of figure 7 and the potential at times t₁ to t₄ at the charge input mode. Figure 8(b) schematically shows waveforms of signals that are applied to the respective terminals.

Clock pulses I, φ1, and φ2 are applied to the charge input terminal 10, and signal input terminals of the transfer electrodes 11 and 12, respectively, and dc voltages V_{GIL} and V_{GIH} are applied to the signal input terminals of the charge input controlling gates 8 and 9, respectively.

First, at time t₁, the charge input terminal 10 and the transfer electrode 12 are at "H" level while the transfer electrode 11 is at "L" level.

At time t₂, the input signal I of the charge input terminal 10 becomes "L" level and charges are transferred from the charge input terminal 10 to the potential well beneath the input controlling gates 8 and 9. At time t₃, the charge input terminal 10 again becomes "H" level and the input charges Q₀ are stored in the potential well beneath the input controlling gate 9.

At time t₄, φ1 is at "H" level while φ2 is at "L" level and then the transfer electrode 11 becomes "H" level and the transfer electrode 12 becomes "L" level, whereby measured charges Q₀ are transferred to the potential well beneath the CCD transfer electrode.

Next, operation at the time of imaging mode will be described hereinafter.

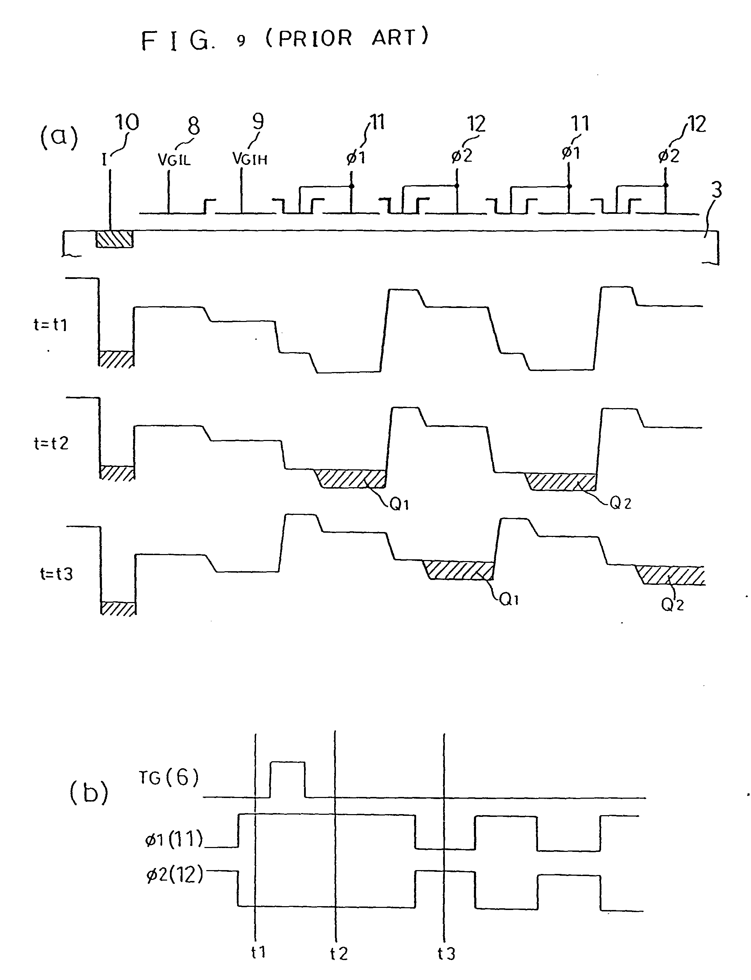

Figure 9 (a) is a diagram schematically showing a cross-section taken along a line C-C' of figure 7 and the potential at times t₁ to t₃ at the imaging mode. Figure 9(b) schematically shows waveforms of signals applied to the respective terminals.

Clock pulses φ1 and φ2 are applied to the signal input terminals of the transfer electrodes 11 and 12, respectively, and dc voltages V_{GIL} and V_{GIH} are applied to the signal input terminals of the charge input controlling gates 8 and 9, respectively.

Between times t₁ and t₂, the transfer gate (TG) 6 is opened and the signal charges Q₁ and Q₂ detected respectively in the light receiving elements 4-1 and 4-2 are transferred to the potential wells beneath the corresponding transfer electrodes 11.

At time t₃, the signal φ1 of the transfer electrode 11 is set to "H" level and the signal φ2 of the transfer electrode 12 is set to "L" level, whereby the signal charges Q₁ and Q₂ are transferred to the potential wells beneath the transfer electrodes 12 at the next stage. Thereafter, by repeating this operation, the signal charges are synchronized with the clock pulses and successively transferred.

Since the charge input part 2 of this linear image sensor is constituted as described above, the array pitch of the light receiving element 4 at the charge transfer part 2 is unfavorably larger than elsewhere.

More specifically, in a case where the width of the transfer electrodes 11 and 12 is 8 µm and the interval between the adjacent light receiving elements 4-1 and 4-2 (in figure 7, ℓ₁) is 16 µm, the interval between the light receiving elements 4-1 (in figure 7, ℓ₂) is required to be 31 µm when the width of the charge input terminal is 4 µm and the widths of the charge input controlling gates 8 and 9 are 3 µm and 4 µm, respectively.

When the space of the charge input part 2 is large and the array pitch of the light receiving element 4 corresponding to this part is large, resolution is sharply lowered at the charge input part 2, so that a uniform resolution over the chip cannot be obtained.

US-A-4 647 977 discloses a solid state imaging device comprising a pair of horizontal charge coupled devices (CCD's) arranged in series with a multiplex output section arranged therebetween. Each element of a linear array of light-receiving elements is coupled to a respective stage of the horizontal CCD's via vertical CCD shift registers. These latter have a fanned arrangement so that a uniform element spacing is possible for the linear array. Other features of this disclosure are recited in the preamble of the main claim appended hereto.

The solid state image device according to the present invention is characterised in that the charge input means comprises a first electrode and second electrode adjacent to, and downstream of, the first electrode;
a first one of the light receiving elements coupled to a region under the second electrode which the first region is part of the initial stage of the charge-coupled device; and
supply means is arranged to supply, to the first electrode, a first dc voltage during charge input and image read-out modes, and to the second electrode, a second dc voltage during the charge input mode, and a clock signal synchronised with one of the clock pulses during the image read-out mode.

The aforesaid structure is of particular advantage when the charge coupled device and another are arranged with the charge input means therebetween. Since the second electrode of the charge input means is also provided as a first stage transfer electrode to transfer image charge, the structure is compact and the light-receiving elements can be arranged at a uniform spacing - i.e. without a larger spacing between the elements adjacent to the charge input means.

In the accompanying drawings:
Figure 1 is a plan view showing an input part of a one-dimensional solid-state imaging device in accordance with a preferred embodiment of the present invention;
Figure 2(a) is a diagram showing a cross-section taken along a line A-A' of figure 1 and the potential at the time of charge input mode and figure 2(b) is a diagram schematically showing waveforms of signals applied to the respective terminals;
Figure 3(a) is a diagram showing a cross-section taken along a line A-A' of figure 1 and the potential at the time of an imaging mode and figure 3(b) is a diagram schematically showing waveforms of signals applied to the respective terminals;
Figures 4(a) and 4(b) respectively are plan views showing a two-dimensional solid-state imaging device, and an input part thereof in accordance with the preferred embodiment of the present invention;
Figure 5 is a plan view showing an alternative of the two-dimensional solid-state imaging device in accordance with the preferred embodiment of the present invention;
Figure 6 is a plan view showing a one-dimensional solid-state imaging device in accordance with not published prior art;
Figure 7 is a plan view showing a charge input part of the device shown in figure 6;
Figure 8(a) is a diagram showing a cross-section taken along a line C-C' of figure 7 and the potential at the time of charge input mode and figure 8 (b) is a diagram schematically showing waveforms of signals applied to the respective terminals; and
Figure 9 (a) is a diagram showing a cross-section taken along a line C-C' of figure 7 and the potential at the time of imaging mode and figure 9 (b) is a diagram schematically showing waveforms of signals applied to the respective terminals.

A preferred embodiment of the present invention will be described in detail with reference to the drawings.

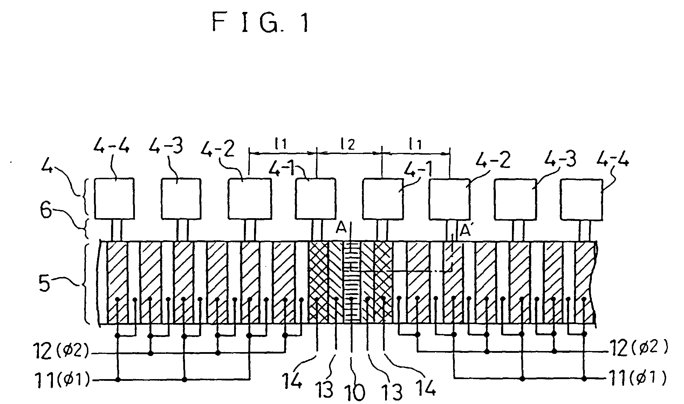

Figure 1 is a plan view schematically showing a structure of a solid-state imaging device in accordance with a preferred embodiment of the present invention, in which a charge input means is provided at the centre of the structure and two CCDs are serially arranged with the charge input means therebetween. In figure 1, a light-to-electricity conversion part 4 is constituted by a plurality of light receiving elements 4-1, 4-2, 4-3, 4-4 ... . Signal charges detected in the light-to-electricity conversion part 4 are transferred to the CCDs 5 via the transfer gates 6 by the ON operation of the transfer gates 6. Reference numerals 11 and 12 designate transfer electrodes of the CCDs 5 and numerals φ1 and φ2 are input signals applied to the transfer gates 11 and 12. Reference numeral 10 designates an electrode input terminal for electrically injecting charges into the CCDs 5 from outside. First charge input controlling gates 13 are provided adjacent to the charge input terminal 10 and control the charges input from the charge input terminal 10. Common gates 14 are provided adjacent to the first charge input controlling gates 13 and serve both as second charge input controlling gates and initial stage transfer electrodes. The common gates 14 serve as the second input controlling gates at the time of charge input mode and as the transfer gates like the transfer electrodes 11 at the time of imaging mode.

Operation at the charge input mode will be described hereinafter.

As described above, in the charge input mode, the common gates 14 serve as the second charge input controlling gates with the first charge input controlling gates 13 and they function in the same way as the charge input controlling gates 8 and 9 of the prior art device.

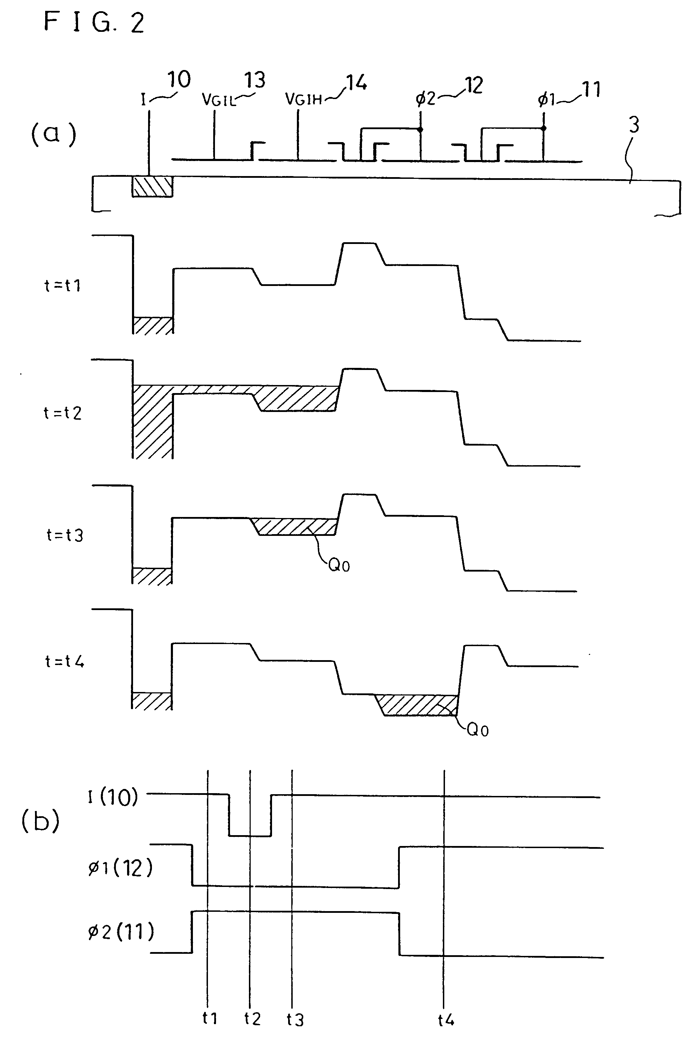

Figure 2(a) shows a cross-section taken along a line A-A' of figure 1 and the potential at times t₁ to t₄. Figure 2(b) schematically shows waveforms of signals applied to the respective terminals.

Clock pulses I, φ1 and φ2 are applied to the charge input terminal 10 and the transfer electrodes 11 and 12, respectively, while dc voltages V_{GIL} and V_{GIH} are applied to the first charge input controlling gate 13 and the common gate 14, respectively. The quantity of the input charge is measured by the difference in voltages applied to the gates 13 and 14 and controlled to be a desired value.

Between times t₁ and t₂, charges are transferred from the charge input terminal 10 to the potential well beneath the input controlling gate 13 and the common gate 14. At time t₃, the charge input terminal 10 becomes "H" level again and the measured input charges Q₀ are stored in the potential well beneath the common gate 14.

At time t₄, the transfer electrode 12 becomes "H" level and the charges Q₀ are transferred to the potential well beneath the CCD transfer electrode 12.

Thus, the charge input operation can be performed in the same way as in the prior art device.

Operation in the imaging mode will be described hereinafter.

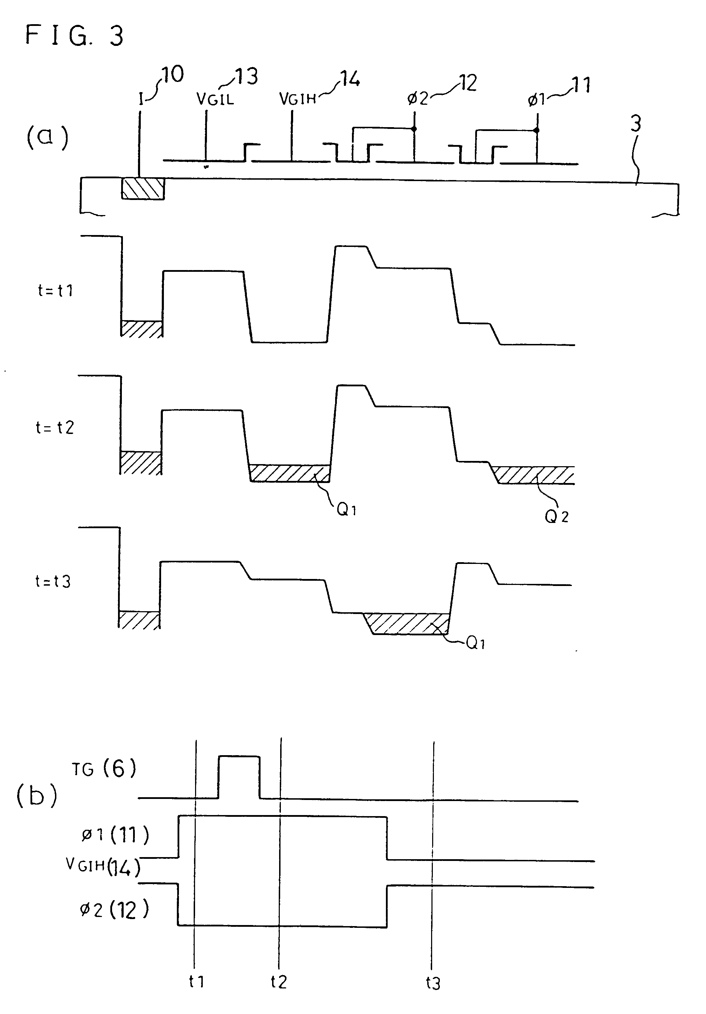

Figure 3(a) shows a cross-section taken along a line A-A' of figure 1 and the potential at times t₁ to t₃. Figure 3(b) schematically shows waveforms of signals applied to the respective terminals.

A clock pulse having the same phase as that applied to the transfer electrode 11 is applied to the common gate 14 and a dc voltage is applied to the charge input controlling gate 13.

Between times t₁ and t₂, the transfer gates 6 are opened and signal charges Q₁ and Q₂ stored in the light receiving elements 4-1 and 4-2, respectively, are transferred to the potential wells beneath the common electrode 14 and the transfer electrode 11, respectively. Thereafter, the transfer electrode 11 and the common electrode 14 are set to "L" level and the transfer electrode 12 is set to "H" level by applying clock pulses and then the signal charges Q₁ beneath the common electrode 14 are transferred to the potential well beneath the transfer electrode 12 and the charges Q₂ beneath the transfer electrode 11 are transferred to the potential well beneath the next stage transfer electrode. In this way, signal charges synchronized with the clock pulses are successively transferred like the prior art image sensor.

In this embodiment of the present invention, since the electrode 14 serves both as the second electrode for controlling the quantity of input charge and the initial stage transfer electrode for transferring signal charges, the array pitch of the light receiving elements at the charge input part is as follows with employing the conventional design basis as it is.

In case where the width of the transfer gates 11 and 12 is 8 µm and the interval ℓ1 between adjacent light receiving elements other than those at the charge input part is 16 microns like the prior art device, by setting the width of the charge input terminal 10 to 4 µm and the widths of the charge input controlling gate 13 and the common gate 14 to 3.5 µm and 5 µm, respectively, the interval ℓ2 between the light receiving elements 4-1 at the charge input part 2 can also be 16 µm.

Accordingly, in this embodiment, the spacing of the charge input part 2 can be reduced without changing the scale of the electrode input terminal and the charge input controlling gate, and the array pitch of the light receiving elements corresponding to the charge input part can be equal to the array pitch of the light receiving elements at the other parts.

As described above, the charge input controlling electrode and the transfer electrode are constituted by the same electrode 14. A dc voltage is applied to the electrode 14 at the time of charge input mode so that it may serve as the second charge input controlling electrode and a clock pulse is applied thereto at the time of imaging mode so that it may serve as the transfer electrode. Therefore, the space of the charge input part 2 can be reduced and the array pitch of the light receiving elements corresponding to the charge input part can be equal to the array pitch of the light receiving elements corresponding to the other parts, whereby the pattern design can be simplified. In addition, no reduction in resolution occurs at the charge input part and a uniform resolution can be obtained in the chip.

While a one-dimensional solid-state imaging device has just been described, the present invention also can be applied to a two-dimensional solid-state imaging device.

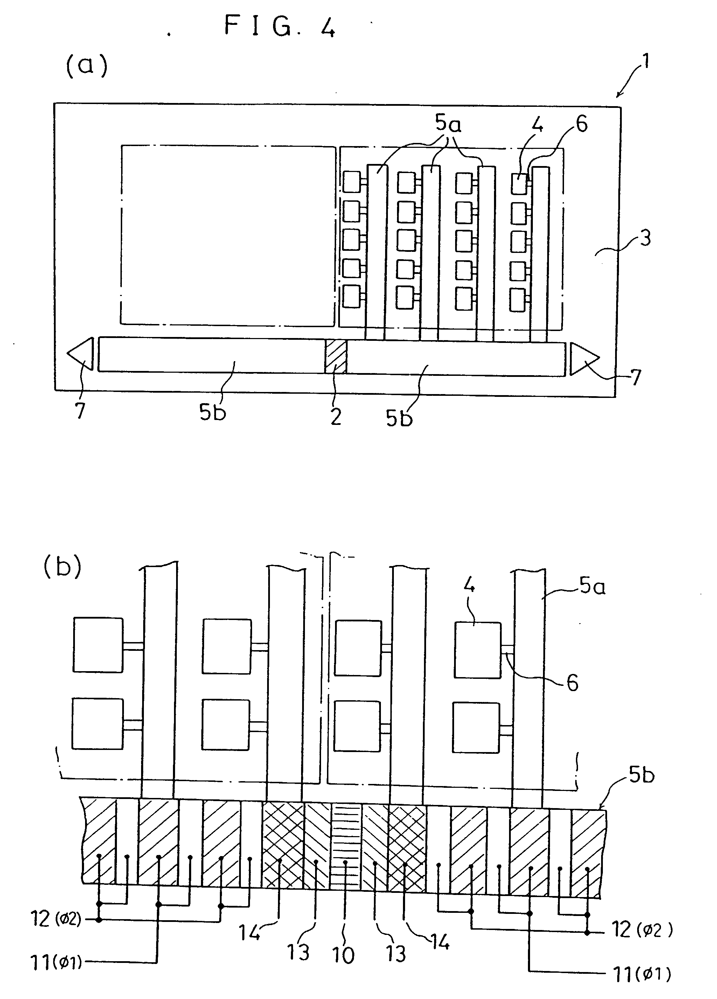

Figure 4(a) is a plan view showing a two-dimensional solid-state imaging device in which the charge input part 2 of the above embodiment is applied to a horizontal CCD, and figure 4(b) is a plan view showing the charge input part 2 and its vicinity in detail. In these figures, the same references as those shown in figure 1 designate the same parts, and reference numerals 5a and 5b designate vertical CCDs and horizontal CCDs, respectively. The structure of the charge input part 2 is similar to that shown in figure 1 according to the first embodiment except that image signals are input from light receiving elements via vertical CCDs 5a.

In this structure, the two-dimensional solid-state imaging device is divided in the middle and signal charges detected in the light receiving elements 4 are transferred to the vertical CCDs 5a through the transfer gates 6. Signal charges transferred from the vertical CCDs 5a are read out simultaneously by the two horizontal CCDs 5b.

Also in this structure, the common gates 14 are provided in the charge input part 2 between the horizontal CCDs 5b, and a dc voltage is applied to the common gates 14 at the time of charge input mode so that they may serve as charge input controlling gates and a clock pulse synchronized with the transfer electrode 11 is applied thereto at the time of imaging mode so that they may serve as transfer electrodes of the CCDs 5. Thus, similarly as discussed above, the space of the charge input part 2 can be reduced and the array pitch of the light receiving elements corresponding to this part can be equal to the array pitch of light receiving elements corresponding to the transfer electrode parts. As a result, a reduction in resolution, which is caused by the provision of the charge input part, can be prevented.

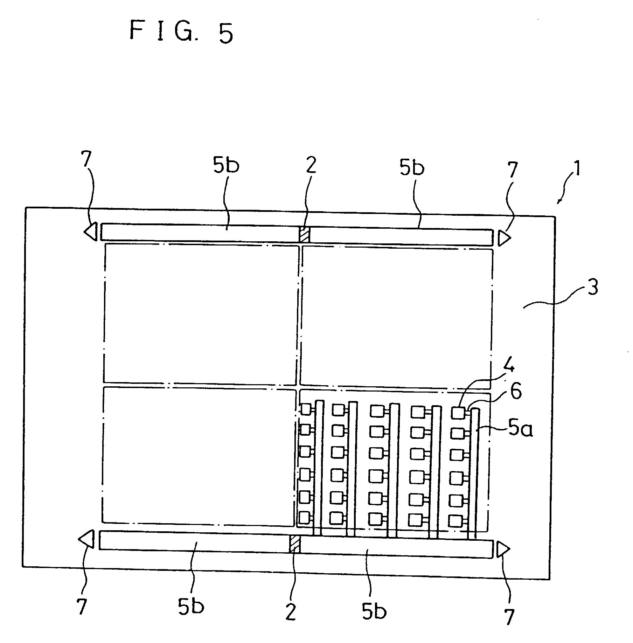

Figure 5 is a plan view showing another structure of two-dimensional solid-state imaging device, in which two two-dimensional solid-state imaging devices shown in figure 2 are symmetrically arranged on the semiconductor substrate 3. Also in this structure, when the charge input part 2 of the preferred embodiment is employed, all the light receiving elements 4 can be arranged at the same pitch, whereby the pattern production can be simplified and an uniform resolution can be obtained in the chip.

## Claims

1. A solid state imaging device comprising:
a first charge-coupled device (5);
a first plurality of light receiving elements (4-1 to 4-4), each coupled through a transfer gate (6) to a respective stage of said first charge-coupled device (5),
charge input means (2) for controlling a quantity of charge input from a charge input source (10) to the initial stage of said first charge-coupled device; and
clocking means arranged to supply clock pulses (φ₁, φ₂) to the transfer electrodes (11,12) of said first charge-coupled device to transfer charges (Q₀,Q₁,Q₂) along said first charge-coupled device,
characterised in that:
said charge input means (2) comprises a first electrode (13) and a second electrode (14) adjacent to, and downstream of, said first electrode (13);
a first one (4-1) of said light receiving elements (4-1) is coupled to a region under said second electrode (14) which region is part of the initial stage of said first charge-coupled device (5); and
supply means is arranged to supply, to the first electrode (13), a first dc voltage (V_{GIL}) during charge input and image read-out modes, and to the second electrode (14), a second dc voltage (V_{GIH}) during the charge input mode, and a clock signal synchronised with one of said clock pulses (φ₁, φ₂) during the image read-out mode.

2. A solid state imaging device according to claim 1 including:
a second charge-coupled device (5) arranged in series with said first charge-coupled device (5) with said charge input means (2) therebetween; and
a second plurality of light receiving elements (4-1 to 4-4) each coupled through a transfer gate (6) to a respective stage of said second charge-coupled device; wherein
the transfer electrodes (11,12) of said second charge-coupled device are connected to said clocking means to receive said clock pulses (φ₁,φ₂);
said charge input means (2) includes another first electrode (13) and another second electrode (14) adjacent to and downstream of said another first electrode (13) in the transfer direction of said second charge-coupled device away from said input means (2);
said another first and second electrodes (13,14) are connected to said supply means likewise to receive said first and second dc voltages (V_{GIL},V_{GIH}) and said synchronised clock signal; and
a first one (4-1) of the light receiving elements (4-1 to 4-4) of said second plurality is coupled to a region under said another second electrode (14), which region is part of the initial stage of said second charge-coupled device (5).

3. A solid state imaging device according to claim 2, wherein the spacings (ℓ₁) of said light receiving elements of each first and second plurality and the spacing (ℓ₂) between said first one (4-1) of said first plurality and said first one (4-1) of said second plurality are equal.

4. A solid state imaging device according to any preceding claim, wherein respective third charge-coupled devices (5a) are interposed between respective stages of said first, or of said first and second, charge-coupled devices (5b) and respective ones of said light receiving elements (4) with respective transfer gates(6).

## Patentansprüche

1. Festkörper-Bildaufnahmevorrichtung mit:
einem ersten Ladungsspeicherlement (5);
einer ersten Mehrzahl von Lichtaunahmeelementen (4-1 bis 4-4), wobei jedes durch ein Übertragungsgatter (6) an eine entsprechende Stufe des ersten Ladungsspeicherelements (5) gekoppelt ist,
einer Ladungseingabeeinrichtung (2) zum Steuern der Größe einer Ladung, die von einer Ladungseingabequelle (10) der Anfangsstufe des ersten Ladungsspeicherelements eingegeben wird; und
einer Takteinrichtung, die zum Einspeisen von Taktpulsen (φ₁, φ₂) den Übertragungselektroden (11, 12) des ersten Ladungsspeicherelements ausgebildet ist, um Ladungen (Q₀, Q₁, Q₂) dem ersten Ladungsspeicherelement zu übertragen,
dadurch gekennzeichnet, daß
die Ladungseingabeeinrichtung (2) eine erste Elektrode (13) und eine zu der ersten Elektrode (13) benachbart und stromab angeordnete zweite Elektrode (14) aufweist;
ein erstes Element (4-1) der Lichtempfangselemente (4-1) an ein Gebiet unter der zweiten Elektrode (14) gekoppelt ist, wobei das Gebiet Teil der Anfangsstufe des ersten Ladungsspeicherelements (5) ist; und
eine Einspeiseeinrichtung vorgesehen ist, um der ersten Elektrode (13) eine erste Gleichspannung (V_{GIL}) während der Ladungseingabe- und Bildlesebetriebsart und der zweiten Elektrode (14) eine zweite Gleichspannung (V_{GIH}) während der Ladungseingabebetriebsart und ein mit einem der Taktpulse (φ₁, φ₂) synchronisiertes Taktsignal während der Bildlesebetriebsart einzuspeisen.

2. Festkörper-Bildaufnahmevorrichtung nach Anspruch 1, gekennzeichnet durch:
ein zweites Ladungsspeicherelement (5), welches in Serie mit dem ersten Ladungsspeicherelement (5) und der dazwischen befindlichen Ladungseingabeeinrichtung (2) angeordnet ist; und
eine zweite Mehrzahl von Lichtempfangselementen (4-1 bis 4-4), wobei jedes durch ein Übertragungsgatter (6) an eine entsprechende Stufe des zweiten Ladungsspeicherelements gekoppelt ist; wobei
die Übertragungselektroden (11, 12) des zweiten Ladungsspeicherelements mit der Takteinrichtung verbunden sind, um die Taktpulse (φ₁, φ₂) zu empfangen;
die Ladungseingabeeinrichtung (2) eine andere erste Elektrode (13) und eine benachbart zu und stromab der anderen ersten Elektrode (13) in Übertragungsrichtung des zweiten Ladungsspeicherelements weg von der Eingabeeinrichtung (2) angeordnete andere zweite Elektrode (14) enthält;
die anderen ersten und zweiten Elektroden (13, 14) mit der Einspeiseeinrichtung ebenso verbunden sind, um die ersten und zweiten Gleichspannungen (V_{GIL}, V_{GIH}) und das synchronisierte Taktsignal zu empfangen; und
ein erstes Element (4-1) der Lichtempfangselemente (4-1 bis 4-4) der zweiten Mehrzahl an ein Gebiet unter der anderen zweiten Elektrode (14) gekoppelt ist, wobei das Gebiet Teil der Anfangsstufe des zweiten Ladungsspeicherelements (5) ist.

3. Festkörper-Bildaufnahmevorrichtung nach Anspruch 2, dadurch gekennzeichnet, daß die Abstände (l₁) der Lichtempfangselemente der ersten und zweiten Mehrzahl und die Abstände (l₂) zwischen dem ersten Element (4-1) der ersten Mehrzahl und dem ersten Element (4-1) der zweiten Mehrzahl gleich sind.

4. Festkörper-Bildaufnahmevorrichtung nach einem der vorausgehenden Ansprüche, dadurch gekennzeichnet, daß jeweils dritte Ladungsspeicherelemente (5a) zwischen den jeweiligen Stufen der ersten oder der ersten und zweiten Ladungsspeicherelemente (5b) und den jeweiligen Elementen der Lichtempfangselemente (4) mit jeweiligen Übertragungsgattern (6) angeordnet sind.

## Revendications

1. Dispositif d'imagerie à solide comprenant :
un premier dispositif à charges couplées (5);
une première pluralité d'éléments de réception de lumière (4-1 à 4-4), chacun couplé par une porte de transfert (6) à un étage respectif dudit premier dispositif à charges couplées (5),
un moyen d'entrée de charges (2) pour contrôler une quantité d'entrée de charges d'une source d'entrée de charges (10) à l'étage initial dudit premier dispositif à charges couplées; et
un moyen d'horloge agencé pour appliquer des impulsions d'horloge (φ₁, φ₂) aux électrodes de transfert (11,12) dudit premier dispositif à charges couplées pour transférer des charges (Q₀, Q₁, Q₂) le long dudit premier dispositif à charges couplées,
caractérisé en ce que :
ledit moyen d'entrée de charges (2) comprend une première électrode (13) et une seconde électrode (14) adjacentes à ladite première électrode (13) et en aval de celle-ci;
un premier (4-1) desdits éléments de réception de lumière (4-1) est couplé à une région sous ladite seconde électrode (14), laquelle région fait partie de l'étage initial dudit premier dispositif à charges couplées (5); et
un moyen d'alimentation est agencé pour fournir, à la première électrode (13), une première tension continue (V_{GIL}) pendant des modes d'entrée de charges et d'extraction d'image, et à la seconde électrode (14), une seconde tension continue (V_{GIH}) pendant le mode d'entrée de charges et un signal d'horloge synchronisé par l'une desdites impulsions d'horloge (φ₁, φ₂) pendant le mode d'extraction d'image.

2. Dispositif d'imagerie à solide selon la revendication 1 comprenant :
un second dispositif à charges couplées (5) agencé en série avec le premier dispositif à charges couplées précité (5) avec le moyen d'entrée de charges précité (2) entre eux; et
une seconde pluralité d'éléments de réception de lumière (4-1 à 4-4) chacun couplé par une porte de transfert (6) à un étage respectif dudit second dispositif à charges couplées; dans lequel
les électrodes de transfert (11,12) dudit second dispositif à charges couplées sont reliées au moyen d'horloge précité pour recevoir les impulsions d'horloge précitées (φ₁,φ₂);
ledit moyen d'entrée de charges (2) comprend une autre première électrode (13) et une autre seconde électrode (14) adjacente à ladite autre première électrode (13) et en aval de celle-ci dans la direction de transfert dudit second dispositif à charges couplées au loin dudit moyen d'entrée (2);
lesdites autres première et seconde électrodes (13,14) sont reliées au moyen d'alimentation précité de la même manière pour recevoir les première et seconde tensions continues précitées (V_{GIL},V_{GIH}) et le signal d'horloge synchronisé précité; et
un premier (4-1) des éléments de réception de lumière (4-1 à 4-4) de ladite seconde pluralité est couplé à une région sous ladite autre seconde électrode (14), laquelle région fait partie de l'étage initial dudit second dispositif à charges couplées (5).

3. Dispositif d'imagerie à solide selon la revendication 2, dans lequel les espacements (ℓ₁) des éléments de réception de lumière précités de chaque première et seconde pluralités et l'espacement (ℓ₂) entre le premier précité (4-1) de la première pluralité précitée et le premier précité (4-1) de la seconde pluralité sont égaux.

4. Dispositif d'imagerie à solide selon l'une quelconque des revendications précédentes, dans lequel des troisièmes dispositifs à charges couplées respectifs (5a) sont interposés entre des étages respectifs dudit premier ou desdits premier et second dispositifs à charges couplées (5b) et ceux respectifs des éléments de réception de lumière précitées par des portes de transfert respectives (6).
